# EUROPEAN PATENT APPLICATION

(11) **EP 2 416 167 A1**
(43) Date of publication of application: **08.02.2012**
(21) Application number: 09840670.5
(22) Date of filing: 23.12.2009
(51) Int. Cl.: G01R 31/06, H02H 7/045

(54) **IMPROVED TURN-TO-TURN SHORT CIRCUIT DETECTION DEVICE OF TRANSFORMER VIA DIFFERENTIAL VOLTAGE**

(30) Priority: 28.02.2009 CN 200910096404
(71) Applicant: Zhejiang Guangtian Transformer Co., Ltd, Taizhou, Zhejiang 318020 (CN)
(72) Inventor: ZHAO, Xiping, Zhejiang 318020 (CN)
(74) Representative: Fenlon, Christine Lesley
(86) International application number: PCT/CN2009/075894
(87) International publication number: WO 2010/097002

(57) **Abstract**

A detector for transformer winding short circuit using voltage differential, comprising a single-phase transformer (TM) in single-phase high voltage power supply circuit, said single-phase transformer (TM) comprising high voltage winding (K) and low voltage winding (N) and provided on its high voltage side with a potential transformer (PT), wherein a high voltage is drawn from tap (K1) of high voltage winding (K), said tap (K1) being coupled to the input end of a first converter (Q') of which the voltage at output end is the first voltage (U1'), and a secondary voltage is drawn from the secondary side of potential transformer (PT), said secondary side being coupled to the input end of a second converter (Q) of which the voltage at output end is the secondary voltage (U1), both output ends of the first converter (Q') and the second converter (Q) being coupled to the module to distinguish interturn short circuit at the first output side, and in said module comparing the first voltage (U1') with the secondary voltage (U1), when voltage differential is larger than a preset first threshold value, an interturn short circuit at the first output side being determined; a low voltage is drawn from tap (N1) of low voltage winding (N), said tap (N1) being coupled to the input end of a third converter (M') of which the voltage at output end is the third voltage (U2'), and both ends of low voltage winding (N) being coupled to the input end of the fourth converter (M) of which the voltage at output end is the fourth voltage (U2), both output ends of the third converter (M') and the fourth converter (M) being coupled to a module to distinguish interturn short circuit at the secondary output side, and in said module comparing the third voltage (U2') and the fourth voltage (U2), when voltage differential is larger than a preset secondary threshold value, an interturn short circuit at secondary output side being determined.

## Description

### Field of the Invention

This invention relates to an improved detector for transformer interturn short circuit using voltage differential, in particular for detection of and protection from transformer interturn short circuit when it occurs.

### Description of the Prior Art

With the expansion of city scale, electrical transformer is rapidly increasing in quantity and capacity. However at present, except large-capacity transformers and those transformers with special requirement which are installed with current pilot differential detection to provide severe interturn and interphase short-circuit protection, or medium-capacity oil-immersed transformers which are protected by installing a Buchholz relay, all other oil-immersed or dry transformers of less than 6300 KVA have not been installed with protective circuit for detecting early failure of interturn or interphase short circuit. These equipment that are not installed with interturn or interphase short circuit protection in accordance with relay protection design code generally have the following problems: (1) when interturn or interlayer short circuit occurs due to internal or external cause, the transformer cannot detect the initial low-energy state failure and thus allowing the failure to expand until severe accidents caused by large-capacity short circuit, such as a fire, triggers protective action at high voltage input terminal; expansion of failure makes the repairing of the transformer more difficult, especially large-scaled failure may damage the overflow protection of transformer substation at a higher level, causing severe damage to the safety of electricity supply and human body, (2) once an interturn short circuit occurs and the transformer cannot determine the type of failure through analysis, it becomes very difficult to provide corresponding protection. Hence, this applicant designed a detector for transformer interturn short circuit using voltage differential and applied for a Chinese patent (No. 200820081814.2). However, the technical scheme of that patent has the following shortcomings: (1) a third coil must be installed in the transformer body. However, after the transformer coil is installed, it is hard to install the third coil inside the transformer body, so that it is unable to extract signals and application extent is limited; (2) the signal sensed from the third coil may be affected by its load and its properties (resistance, capacity and inductance) and thus may not satisfy the requirement of differential protection; (3) the conversion using the same iron core in the comparison of the sample voltage signal in original patent and the voltage signal of main winding (3) the first sampling voltage signal is compared with the voltage signal of main winding and uses the same iron core (winding) for transmission. It may cause short circuit of sampling signal and could not realize signal comparison, additionally with low efficiency and poor precision.

### Summary of the Invention

The object of the present invention is to overcome the shortcoming of existing technique by providing an improved, effective and high precision detector for transformer interturn short circuit using voltage differential that is feasible in manufacturing technique, unaffected by its load and its properties (resistance, capacity and inductance), and satisfies the requirement of differential protection. The sampling voltage signal from the detector is compared with the voltage signal of main coil converted by individual converter to avoid affecting test signal.

The partial sampling voltage signal from the detector is compared with the full voltage signal of main coil converted by individual converter to avoid affecting test signal.

The technical scheme of the improved detector for transformer winding short circuit using voltage differential of this invention is: an improved detector for transformer interturn short circuit using voltage differential, comprising a single-phase transformer (TM) in single-phase high voltage power supply circuit. The single-phase transformer (TM) comprises high voltage winding (K) and low voltage winding (N). A potential transformer (PT) is provided on high voltage side of single-phase transformer (TM). A high voltage is drawn from tap (K1) of high voltage winding (K). The tap (K1) of high voltage winding (K) is coupled to the input end of a first converter (Q') and the voltage at output end of said first converter (Q') is the first voltage (U1'). A second voltage is drawn from the secondary output side of potential transformer (PT) that is coupled to the input end of a second converter (Q). Both output ends of the first converter (Q') and the second converter (Q) are coupled to a module to distinguish interturn short circuit at the first output side. The first voltage (U1') and the second voltage (U1) are compared in the said module. When voltage differential is larger than a preset first threshold value, an interturn short circuit at first output side can be determined.

A low voltage is drawn from tap (N1) of low voltage winding (N) coupled to the input end of a third converter (M') and the voltage at output end of said third converter (M') is the third voltage (U2'). Both ends of low voltage winding (N) are coupled to the input end of a fourth converter (M) and the voltage at output end of said fourth converter (M) is the fourth voltage (U2). Both output ends of the third converter (M') and the fourth converter (M) are coupled to a module to distinguish interturn short circuit at the secondary output side. The third voltage (U2') and the fourth voltage (U2) are compared in the said module. When voltage differential is larger than a preset secondary threshold value, an interturn short circuit at secondary output side can be determined.

Further, the tap (K1) of high voltage winding (K) comprises two additional connectors from the middle winding of high voltage winding (K) and said two additional connectors are coupled to the input end of the first converter (Q').

Still further, the tap (N1) from low voltage winding (N) is an auxiliary connector from the middle winding of low voltage winding (N). The auxiliary connector and one end of low voltage winding (N) are coupled to the input end of the third converter (M').
comprising a single-phase transformer TM in single-phase high voltage power supply circuit. The single-phase transformer TM comprises high voltage winding K and low voltage winding N. A potential transformer PT is provided on high voltage side of single-phase transformer TM. A high voltage is drawn from tap K1 of high voltage winding coupled to a first converter Q' and converted to a first voltage U1' by the first converter Q'. A second voltage is drawn from potential transformer PT coupled to a second converter Q and converted to a second voltage U1 by the second converter Q. Comparison between the first voltage U1' and the second voltage U1 is conducted and the result is output. Then a low voltage is drawn from tap N1 of low voltage winding N coupled to a third converter M' and converted to a third voltage U2' by the third converter M'. Comparison between the third voltage U2' and the fourth voltage U2 converted by the fourth converter M from full voltage of low voltage winding N is conducted and the result is output.

The electro-mechanical detecting process of the improved detector for transformer winding short circuit using voltage differential of this invention is: installing an individual specific potential transformer PT on high voltage side of the transformer (the potential transformer can be regulated at a gear required by protected transformer); drawing a voltage from high or low voltage winding or any winding that requires detection of short circuit condition either from the taps of a protected winding or preset during manufacturing; feeding the aforementioned voltage to a voltage converter (the power consumption of the voltage converter should not affect the precision of detection and comparison) that will convert sample voltage to U1' and the potential transformer will convert voltage U1. Theoretically, the value of U1' and U1 should be identical. Moreover, partial voltage is drawn from a secondary output side of the transformer, converted to voltage U2 on the secondary output side by converting the sampling voltage from the secondary output side,
that will convert sample voltage to U1' and the potential transformer will convert voltage U1. Theoretically, the value of U1' and U1 should be identical. Moreover, partial voltage is drawn from the secondary output side of transformer, converted to voltage U2 on secondary output side by converting the voltage drawn from the secondary output side,
and compared with converted voltage U2' for correlation comparison. There are two courses of comparison as follows: 1. Compare secondary output side voltage of potential transformer with selected voltage U1', when a voltage difference is less than a predetermined value, determine that no short circuit or accident occurs to primary winding; when the result of comparison exceeds a predetermined range, a protective signal is output to trigger a protecting system, confirming that a short circuit or accident occurs to the transformer high voltage winding. 2. Compare the converted voltage U2 with voltage U2'. When a voltage difference is less than a specific value, no action signal will be output; when a voltage differential exceeds an allowable upper limit, a protective signal is output, confirming that an accident has occurred to the transformer.

The beneficial effects of the present invention are: unaffected with load and its performance (resistance, capacity and inductance); satisfying the requirement of differential protection; the sampling voltage signal from the detector is compared efficiently and precisely with the voltage signal of main coil converted by individual converter to avoid affecting test signal.

### BRIEF DESCRIPTION OF THE DRAWINGS

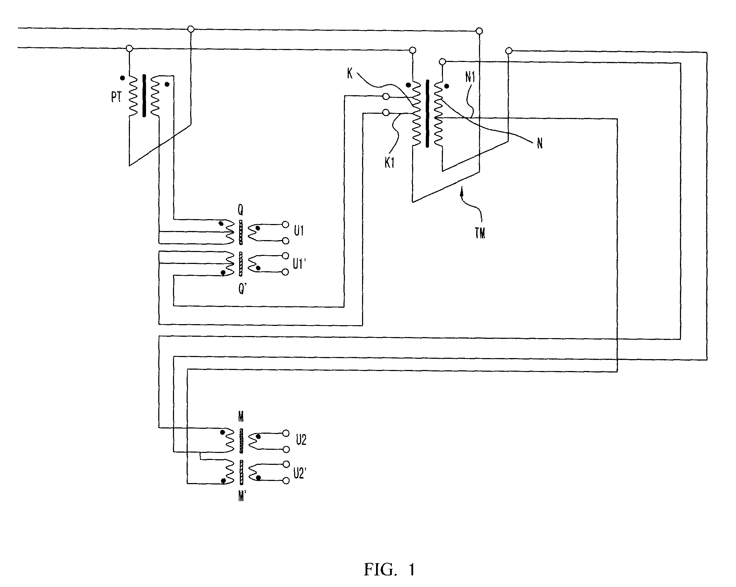

FIG. 1 is a circuit diagram of an improved detector for transformer interturn short circuit using voltage differential.

### DETAILED DESCRIPTION

The present invention relates to an improved detector for transformer interturn short circuit using voltage differential as shown in FIG. 1, comprising a single-phase transformer (TM) in single-phase high voltage power supply circuit. The single-phase transformer (TM) comprises high voltage winding (K) and low voltage winding (N). A potential transformer (PT) is installed on high voltage side of single-phase transformer (TM). A high voltage is drawn from tap (K1) of high voltage winding (K). The tap (K1) of high voltage winding (K) is coupled to the input end of a first converter (Q') and the voltage at output end of said first converter (Q') is the first voltage (U1'). A second voltage is drawn from the secondary output side of potential transformer (PT) that is coupled to the input end of a second converter (Q). Both output ends of the first converter (Q') and the second converter (Q) are coupled to a module to distinguish interturn short circuit at the first output side. The first voltage (U1') and the second voltage (U1) are compared in the said module. When voltage differential is larger than a preset first threshold value, an interturn short circuit at first output side can be determined.

A low voltage is drawn from tap (N1) of low voltage winding (N) coupled to the input end of a third converter (M') and the voltage at output end of said third converter (M') is the third voltage (U2'). Both ends of low voltage winding (N) are coupled to the input end of a fourth converter (M) and the voltage at output end of said fourth converter (M) is the fourth voltage (U2). Both output ends of the third converter (M') and the fourth converter (M) are coupled to a module to distinguish interturn short circuit at the secondary output side. The third voltage (U2') and the fourth voltage (U2) are compared in the said module. When voltage differential is larger than a preset secondary threshold value, an interturn short circuit at secondary output side can be determined.

The tap (K1) of high voltage winding (K) comprises two additional connectors from the middle winding of high voltage winding (K) and said two additional connectors are coupled to the input end of the first converter (Q').

The tap (N1) from low voltage winding (N) is an auxiliary connector from the middle winding of low voltage winding (N). The auxiliary connector and one end of low voltage winding (N) are coupled to the input end of the third converter (M').
comprising a single-phase transformer TM in single-phase high voltage power supply circuit. The single-phase transformer TM comprises high voltage winding K and low voltage winding N. A potential transformer PT is provided on high voltage side of single-phase transformer TM. A high voltage is drawn from tap K1 of high voltage winding coupled to a first converter Q' and converted to a first voltage U1' by the first converter Q'. A second voltage is drawn from potential transformer PT coupled to a second converter Q and converted to a second voltage U1 by the second converter Q. Comparison between the first voltage U1' and the second voltage U1 is conducted and the result is output. Then a low voltage is drawn from tap N1 of low voltage winding N coupled to a third converter M' and converted to a third voltage U2' by the third converter M'. Comparison between the third voltage U2' and the fourth voltage U2 converted by the fourth converter M from full voltage of low voltage winding N is conducted and the result is output.

The electro-mechanical detecting process of the improved detector for transformer winding short circuit using voltage differential of this invention is: installing an individual specific potential transformer PT on a high voltage side of the transformer (the potential transformer can be regulated at a gear required by protected transformer); drawing a voltage from high, low voltage winding or any winding that requires detection of short circuit condition either from the taps of a protected winding or preset during manufacturing; feeding the aforementioned voltage to a voltage converter (the power consumption of the voltage converter should not affect the precision of detection and comparison) that will convert sample voltage to U1' and the potential transformer will convert voltage U1. Theoretically, the value of U1' and U1 should be identical.
that will convert sample voltage to U1' and the potential transformer will convert voltage U1. Theoretically, the value of U1' and U1 should be identical. Moreover, a partial voltage is drawn from a secondary output side of transformer, converted to voltage U2 on the secondary output side by converting the sampling voltage from the secondary output side, and compared with converted voltage U2' for correlation comparison.

There are two courses of comparison as follows: 1. Compare secondary output side voltage of potential transformer with selected voltage U1' when a voltage difference is less than a predetermined value determines that no short circuit or accident occurs to primary winding; when the result of comparison exceeds a predetermined range, a protective signal is output to trigger a protecting system, confirming that a short circuit or accident occurs to the transformer high voltage winding. 2. Compare the converted voltage U2 with voltage U2'. When a voltage difference is less than a predetermined value, no action signal will be output; when the voltage difference exceeds an allowable upper limit, a protective signal is output, confirming that an accident has occurred to the transformer. This circuit is able to determine all conditions of short circuit and output corresponding failure signals, and in particularly determine the characteristics of several failures as follows: (1) During the initial phase of interturn short circuit of transformer, the condition of interturn short circuit is an intermittent halt of energized conductor, characterized by low energy of short circuit and short effect duration. Since the interturn failure occurs intermittently, the variation of turn number affect the transformation ratio. Therefore, processing this signal determines the occurrence of an initial-phase fault and avoid fault extension. (2) The condition of instantaneous high resistance at the timing of a fault is determined and failure signal is output. When short circuit of transformer winding occurs, wire and conductor will be burned out at some point in time. However, the burnout is not at stable state and, due to the role of high voltage and electromagnetic force, the burnout will be reconnected by arc welding at places with broken insulation. Then the reconnected line will be broken out again by current shock upon reconnecting. Such alternation occurs quickly. In this phase, because short circuit does not occur in multiple windings, the fault only produces low energy. However, the variation of transformation ratio will cause sufficient changes at winding breaking points, and allows extraction of a signal of voltage differential circuit fault. (3) When some windings of the transformer are disabled, broken or shortcircuited, the change of winding number will influence transformation ratio and therefore output the signal of short circuit. By comparing the signals converted from partial voltage and complete voltage, the signal characteristic can be used to determine the state of failure and the order of failure severity. Since the failure state is drawn from either high or low voltage side of each phase, we can determine not only whether the fault has occurred at the high voltage or low voltage end , but also determine the phase of accident, thus providing data for repair.

## Claims

1. detector for transformer winding short circuit using voltage differential, comprising a single-phase transformer (TM) in single-phase high voltage power supply circuit, said single-phase transformer (TM) comprising high voltage winding (K) and low voltage winding (N) and provided on its high voltage side with a potential transformer (PT), wherein a high voltage is drawn from tap (K1) of high voltage winding (K), said tap (K1) being coupled to the input end of a first converter (Q') of which the voltage at output end is the first voltage (U1'), and a secondary voltage is drawn from the secondary side of potential transformer (PT), said secondary side being coupled to the input end of a second converter (Q) of which the voltage at output end is the secondary voltage (U1), both output ends of the first converter (Q') and the second converter (Q) being coupled to the module to distinguish interturn short circuit at the first output side, and in said module comparing the first voltage (U1') with the secondary voltage (U1), when voltage differential is larger than a preset first threshold value, an interturn short circuit at the first output side being determined;
a low voltage is drawn from tap (N1) of low voltage winding (N), said tap (N1) being coupled to the input end of a third converter (M') of which the voltage at output end is the third voltage (U2'), and both ends of low voltage winding (N) being coupled to the input end of the fourth converter (M) of which the voltage at output end is the fourth voltage (U2), both output ends of the third converter (M') and the fourth converter (M) being coupled to a module to distinguish interturn short circuit at the secondary output side, and in said module comparing the third voltage (U2') and the fourth voltage (U2), when voltage differential is larger than a preset secondary threshold value, an interturn short circuit at secondary output side being determined.

2. The detector according to claim 1, wherein the tap (K1) of high voltage winding (K) comprises two additional connectors from the middle winding of high voltage winding (K) and said two additional connectors are coupled to the input end of the first converter (Q').

3. The detector differential according to claim 1 or 2, wherein the tap (N1) from low voltage winding (N) is an auxiliary connector drawn from the middle winding of low voltage winding (N) and said auxiliary connector and one end of low voltage winding (N) are coupled to the input end of the third converter (M').
